# EUROPEAN PATENT SPECIFICATION

(11) **EP 0 350 520 B1**
(45) Date of publication and mention of the grant of the patent: **02.03.1994**
(21) Application number: 88111149.6
(22) Date of filing: 12.07.1988
(51) Int. Cl.: H01F 39/00

(54) **Noise filter and method of making the same**
Störschutzfilter
Filtre antiparasites

(43) Date of publication of application: 17.01.1990
(73) Proprietor: Ikeda, Takeshi, Ohta-Ku Tokyo 143 (JP)
(72) Inventor: Ikeda, Takeshi, Ohta-Ku Tokyo 143 (JP)
(74) Representative: Weber, Otto Ernst, Dipl.-Phys.

(56) References cited:
- DE-C- 1 614 379
- US-A- 2 521 513
- US-A- 3 775 720

## Description

### BACKGROUND OF INVENTION

### Field of the Invention:

The present invention relates to a noise filter and a method of making the same and particularly to a four- terminal type noise filter and a method of making the same.

### Description of the Prior Art:

With development of the electronic technology, electronic circuits have been used in a great variety of fields. It is desirable that such electronic circuits function in stable and reliable state without any external affection.

However, direct or indirect affection to the electronic circuits cannot be avoided. This leads to a problem in that various electronic devices utilizing the electronic circuits frequently have malfunctions.

Many electronic circuits use a switching regulator as a source of direct current. Due to transient current on switching or from the variation of load resulting from the switching operation in a digital IC used, noises having various frequency components are frequently produced in the power line of the switching regulator. These noises are transmitted to the other circuit in the same electronic device through the power line or under radiation to create a malfunction or a reduction of S/N ratio. Furthermore, they may raise a malfunction in any one of the other electronic devices used in the vicinity of the electronic device in which the noises are produced.

In order to eliminate the noises, various types of noise filters have been generally used in the electronic circuits. Since the use of high-performance electronic instruments is recently increased, the regulation of noise is being tightened increasingly. It is therefore desired in the art to provide a small-sized and high-performance noise filter which can positively eliminate noises.

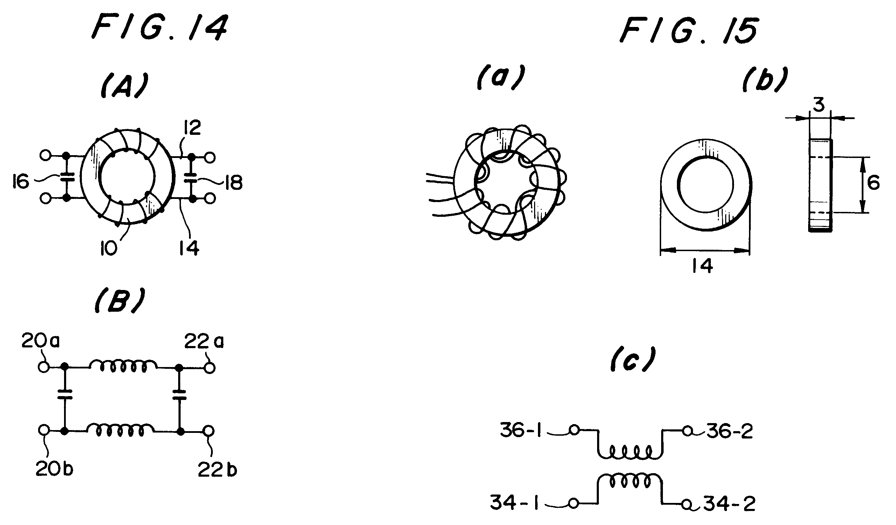

For such a purpose, there is currently used a noise shown in Figure 14B of the accompanying drawings. As shown in Figure 14A, such a conventional noise filter of four-terminal type comprises a core 10, a set of windings 12, 14 wound about the core 10 and capacitors 16, 18 connected parallel to each other between the corresponding ends of the windings 12, 14. Since such an arrangement requires the core 10, it has a problem in that the noise filter itself is increased in size and manufacturing cost in comparison with electronic parts which are being reduced in size and weight.

As seen from Figure 14B, further, the prior art four-terminal type noise filter also is formed as a centralized constant type. This means that such an arrangement cannot eliminate various noises and more particularly common mode noises as in switching surges and normal noises such as ripple noises. If the capacitors or coils are increased in capacity or inductance, a ringing may be undesirably created.

A four-terminal type noise filter of the kind defined by the precharacterizing features of claim 1 is known from the US-A-2,521,513. The strip-like conductors and the dielectric sheets of this known filter are arranged in a cylindrical tube and the inner leads are arranged on a line running in perpendicular to a further line along which the outer leads are arranged. Further, the distance between the inner and the outer leads is relatively great. This arrangement results in a large size and in a relatively complicated method of making the noise filter.

The US-A-3,775,720 is directed to an improvement of the noise filter described in the above-mentioned US-A-2,521, 513 and differs therefrom insofar as it concerns a capacitor-reactor device having separated first and second instead of two continuous conductors and insofar the shape of the final filter is deviating from a cylindrical tube. According to one embodiment this filter has a kind of a flat elliptical shape and the center of the flat laminate is passed by a magnetically permeable core member also surrounding a part of the outer periphery of the flat rolled laminate. Further, the leads respectively the terminals of this filter are arranged in a zick-zack configuration. This known noise filter also is relatively bulky and complicated to manufacture.

### SUMMARY OF THE INVENTION

It is therefore the object of the present invention to provide a four-terminal type noise filter of the kind defined by the precharacterizing features of claim 1 which is reduced in size and which can positively eliminate noises without creation of undesirable events such as ringing and the like.

This object is attained by the characterizing features of claim 1. Advantageous developments of the invention are defined by the method claims.

The present invention provides a four-terminal type noise filter having a superior attenuation and be reduced in seize and weight. Further, the noise filter according to the invention is capable of positively eliminating various noises created in the electronic circuits without creation of ringing. Since the input/output leads are disposed on a straight line passing through the center of the roll shaft with constant spacing, the noise filter in accordance with the invention has a substantially uniform and yet superior attenuation and can be manufactured efficiently in mass-production mode. This means that problems to be considered on manufacturing such distributed constant type noise filters as irregular characteristics from one to other filters or reduced yield can be overcome in accordance with the present invention.

The present invention will now be described with respect to its function.

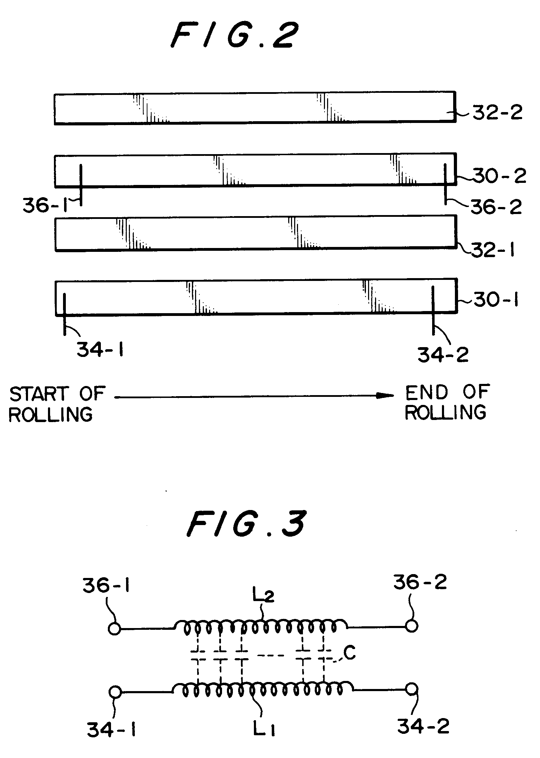

As seen from Figure 2, a four-terminal type noise filter constructed according to the present invention comprises a strip-like conductor 30-1 having first inner and outer input/output leads 34-1, 34-2 which are connected to the conductor 30-1 adjacent the opposite ends thereof, and another strip-like conductor 30-2 having second inner and outer input/output leads 36-1, 36-2 which are connected to the conductor 30-2 adjacent the opposite ends thereof.

A dielectric sheet 32-1 is then superposed on the conductor 30-1 to form a sheet assembly. Similarly, a dielectric sheet 32-2 is superposed on the other conductor 30-2 to form another assembly. The two sheet assembly are then superposed on each other to form a laminate which is, in turn, rolled into a flat tube configuration. In such rolled laminate, the first and second inner leads 34-1, 36-1 are used as a set of input and output terminals while the first and second outer leads 34-2, 36-2 are used as another set of input and output terminals.

Thus, the four-terminal type noise filter of the present invention can function as a common mode noise filter of such a distributed constant type as shown in Figure 3.

More particularly, this noise filter provides an inductance L₁ depending on the length of the strip-like conductor 30-1 between the leads 34-1 and 34-2 and the number of turns in the same. On the other hand, the noise filter provides an inductance L₂ depending on the length of the strip-like conductor 30-2 between the leads 36-1 and 36-2 and the number of turns in the conductor 30-2.

Since the strip-like conductors 30-1 and 30-2 are engaged by each other through the dielectric sheets 32-1 and 32-2, there can be provided a capacitor increased in distributed constant. As seen from Figure 3, the resulting four-terminal type noise filter can function as a distributed constant type noise filter.

Since the four-terminal type noise filter of the present invention functions as such a distributed constant type noise filter as shown in Figure 3, it can provides a better attenuation over a relatively wide band in comparison with the conventional centralized constant type noise filters and eliminate various noises without creation of ringing. The noise filter of the present invention can particularly eliminate common noises due to the effective function of the component L of the distributed constant shown in Figure 3 and also remove normal noises due to the efficient function of the component C of the distributed constant shown in Figure 3.

In accordance with the method of the present invention, a two strip-like conductors (30-1, 30-2) are superposed one on another with dielectric sheets (32-1, 32-2) therebetween to form a laminate which is, in turn, rolled about a rotary roll shaft through a plurality of turns. First and second outer input/output leads 34-2 and 36-2 are connected to the respective strip-like conductors 30-1 and 30-2 adjacent the outer ends thereof such that the leads are positioned substantially on a diametrical line about the central axis of the roll shaft.

Thereafter, the rotary roll shaft is removed from the rolled laminate. The laminate is then pressed in a direction perpendicular to a straight line connecting between the outer leads 34-2 and 36-2 to form an elliptic configuration with the leads 34-1, 34-2, 36-1 and 36-2 arranged substantially on a straight line.

In accordance with the present invention, thus the first and second inner leads 34-1 and 36-1 and the first and second outer leads 34-2 and 36-2 can always be arranged on the straight line. Therefore, there can be provided a four-terminal type noise filter which has a substantially uniform attenuation and which can more effectively be manufactured in a mass-production manner.

Furthermore, the spacing between each adjacent leads can be set at any desired distance. By equalizing the spacing between the leads, thus, the noise filter can more easily be settled on a substrate.

### BRIEF DESCRIPTION OF THE DRAWINGS

Figure 1 illustrates a preferred embodiment of a common mode noise filter constructed according to the present invention.

Figure 2 illustrates a laminate used in the noise filter shown in Figure 1.

Figure 3 is a diagram showing an equivalent circuit in the noise filter of the present invention.

Figure 4 illustrates a modification of the noise filter shown in Figure 1.

Figures 5 to 9 illustrate a second preferred embodiment of a common mode noise filter constructed according to the present invention.

Figure 10 illustrates common mode noises received by a load from a supply of direct current through a power line.

Figure 11 illustrates the common mode noise filter of the present invention connected to the power line.

Figures 12 and 13 illustrate circuits used in tests wherein noises are eliminated by the use of the noise filter according to the present invention.

Figure 14 illustrates a centralized constant type common mode noise filter used in the prior art.

Figure 15 illustrates a conventional toroidal filter with Figure 15A showin the outline thereof, Figure 5B the core used in the filter and Figure 15C the equivalent circuit of this filter.

Figure 16 is a table representing the electrical characteristics of the noise filter according to the present invention and conventional noise filters, all of which noise filters were tested.

Figure 17 is a circuit diagram for confirmatory test of reduction of noises from the switching output power (common noises).

Figure 18 is waveforms in the test performed using the circuit of Figure 17.

Figure 19 illustrates data resulting from the test by the use of the circuit shown in Figure 17.

Figure 20 is a circuit diagram for confirmatory test of reduction of ripple noises in DC line for D-RAM (normal mode noises).

Figure 21 is waveforms in the test performed using the circuit of Figure 20.

Figure 22 illustrates data resulting from the test by the use of the circuit shown in Figure 20.

### DETAILED DESCRIPTION OF PREFERRED EMBODlMENTS

### First Preferred Embodiment:

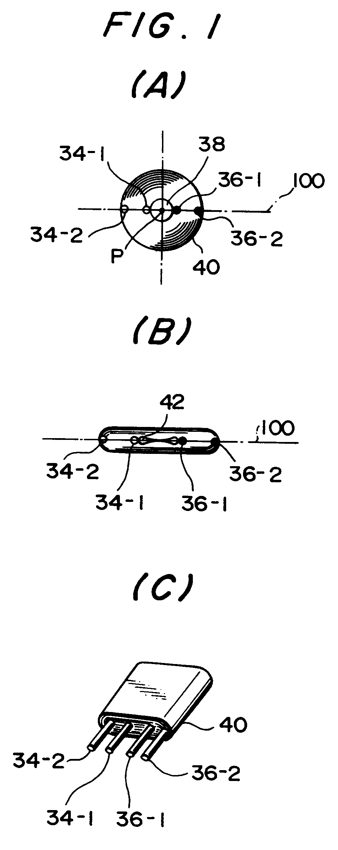

Figure 1 shows a first preferred embodiment of a four-terminal type noise filter to which the principle of the present invention is applied.

To make the noise filter of this embodiment, as shown in Figure 2, two strip-like conductors 30-1 and 30-2 are superposed one on another with dielectric sheets 32-1 and 32-2 to form a laminate. Each of the strip-like conductors 30-1 and 30-2 has its inner end (left end as viewed in Figure 2) adjacent which a first or second input/output leads (34-1; 36-1) is connected to the corresponding conductor.

In the illustrated embodiment, these inner leads 34-1 and 36-1 are to be positioned substantially on a diametrical line 100 about the rotational axis P of a rotary roll shaft 38 when the laminate is rolled about it as will be described.

As shown in Figure 1A, the laminate is then rolled about the rotary roll shaft 38 through a plurality of turns. At this time, a first or second outer input/output lead (34-2; 36-2) is connected to the corresponding strip-like conductor 30-1 or 30-2 adjacent its outer end such that the outer leads 34-2 and 36-2 will be positioned substantially on the diametrical line 100 about the central axis P of the roll shaft 38 in the rolled laminate.

In the illustrated embodiment, the outer leads 34-2 and 36-2 are respectively positioned outside the inner leads 34-1 and 36-1 on the aforementioned diametrical line 100.

After the training end of the roll 40 has been fastened to its body as by means of fusing or adhesion, the winding 40 is removed from the roll shaft 38. The roll 40 is then pressed in a direction perpendicular to the diametrical line 100 connecting the outer leads 34-2 and 36-2 while heating the winding 40. Therefore, the core space of the roll 40 left after the roll shaft 38 is deformed to provide a flat roll as shown in Figure 1B. In such a flat roll, all the leads 34-2, 34-1, 36-1 and 36-2 are arranged in line while at the same time the spacing between each adjacent leads is increased.

If in such a situation, a relationship of $\text{d=(2πr)/2=πr}$ 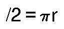 is established where r is the radius of the roll shaft 38 and d is the thickness of the flat roll 40, the leads 34-1, 34-2, 36-2 and 36-2 can be spaced equidistantly one from another.

Although the arrangement of Figures 1A and 1B has the first inner and outer leads 34-1, 34-2 located leftward about the rotational center P and the second inner and outer leads 36-1, 36-2 positioned rightward about the same center P, the other arrangement may be provided in which the first outer and second inner leads 34-2, 36-1 are arranged leftward about the rotational center P and the first inner and second outer leads 34-1, 36-2 are disposed rightward about the same center P.

The resulting noise filter comprises the roll 40 of substantially flat ellipsoid and four in-line type leads 34-2, 34-1, 36-1 and 36-2 extending outwardly from the end of the roll 40, as best seen from Figure 1C.

The noise filter may include a casing of metal foil wound about the outer periphery of the roll 40 or may be coated with epoxy resins, if required.

Since the four-terminal type noise filter of the present invention consists of a substantially elliptic roll formed of strip-like conductors, it can be reduced in size and weight in comparison with such a four-terminal type noise filter of the prior art as shown in Figure 14A and is very preferable for electronic parts which are increasingly being required to reduce in size and weight.

In the noise filter of the present invention, the leads 34-2, 34-1, 36-1 and 36-2 may be more easily mounted on printed substrates since the leads are spaced away from each other with sufficient distance.

In accordance with the present invention, further, the spacing between the leads may be equalized to further promote the attachment of the leads to the printed substrates if there are suitably set the radius r of the roll shaft 38 used, the number of turns in the roll 40 and so on.

The present invention assures that the leads are arranged in line. The noise filter may be more easily be mounted on substrates and yet resist any physical stress externally applied to the noise filter. In addition, the attenuation in the four-terminal type noise filter may be reduced in variability since the spacing between the leads can always be arranged while maintaining it constant. Consequently, the present invention can provide four-terminal type noise filters mass-produced with substantially uniform attenuation and with sufficient reduction of the size.

Furthermore, the noise filter of the present invention functions a distributed constant type noise filter as shown in Figure 3, in which one component L of the distributed constant effectively serves to eliminate the common mode noises and the other component C of the same distributed constant efficiently acts to remove the normal mode noises. The distributed constant type noise filter according to the present invention has a further advantage over the prior art centralized constant type noise filters.

### Second Preferred Embodiment:

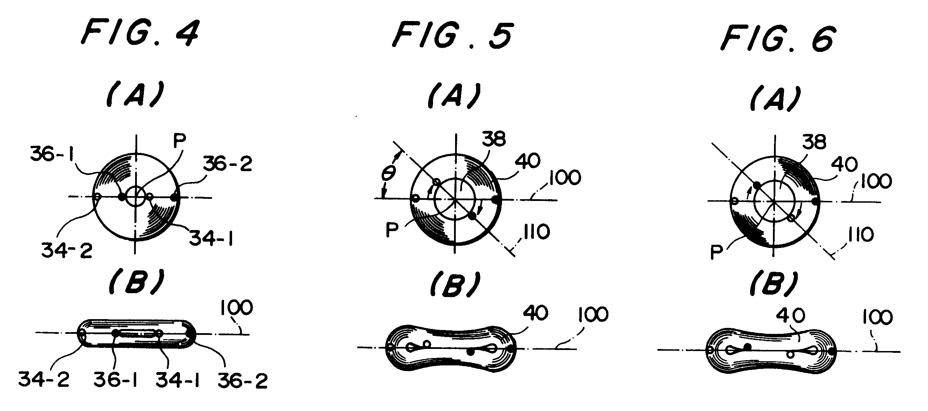

Figures 5 and 6 shows a second preferred embodiment of a four-terminal type noise filter constructed according to the present invention. In the second preferred embodiment outer leads 34-2 and 36-2 are positioned on a diametrical line 100 passing through the rotational center P while inner leads 34-1 and 36-1 are located on another diametrical line 110 intersecting the first diametrical line 100 at the center P with a sharp angle, as seen from Figure 5A or 6A.

As shown in Figure 5B or 6B, a roll 40 formed as in the first embodiment is then pressed in a direction perpendicular to the diametrical line 100 to form a flat noise filter wherein the leads are arranged substantially in line although the linear arrangement thereof is slightly inferior to that of the first embodiment.

The noise filter of the second embodiment is particularly effective when the spacing between the leads is to be set equidistantly if the length of the core space 42 provided by collapsing the roll 40 is equal to or larger than the thickness of the flat roll 40.

In such a situation, by suitably calculating and determining the angle 0 between the diametrical lines 100 and 110 from the relationship between the thickness d of the flat roll 40 and the radius r of the roll shaft 38, it is possible to equidistantly arrange the leads 34-2, 34-1, 36-1 and 36-2 in the same diametrical line, as shown in Figure 5B and 6B.

Where the outer leads 34-2 and 36-2 are positioned on the straight line 100 and the inner leads 34-1 and 36-1 are located the straight line 110, it is required that both the straight lines 100 and 110 are arranged out of orthogonality.

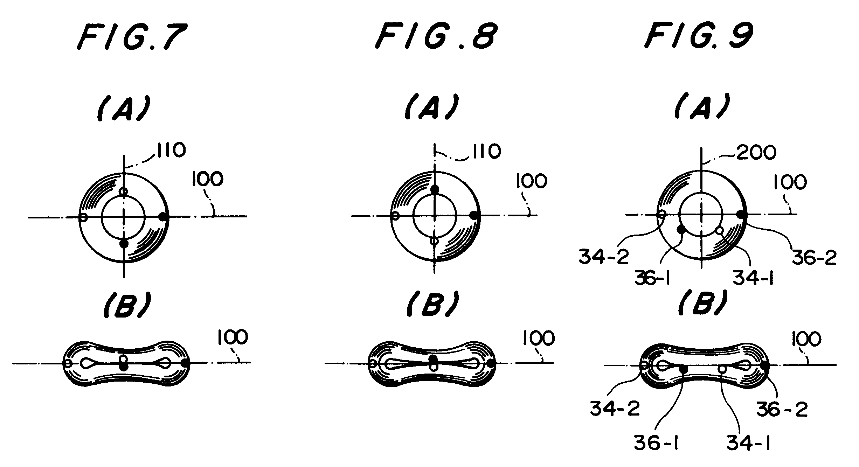

If the straight line 100 extends perpendicular to the straight line 110 and when the roll 40 is collapsed into a flat configuration, the inner leads 34-1 and 36-2 are positioned opposed to each other through a thin insulation sheet, as shown in Figure 7B or 8B. This does not provide a sufficient physical spacing therebetween which leads to a risk of short-circuiting between the inner leads on wiring or soldering.

To provide a noise filter having leads equidistantly spaced one from another, first and second inner leads 34-1 and 36-1 may be positioned symmetrically about a straight line 200 perpendicular to the straight line 100, as shown in Figure 9A. den the roll 40 is collapsed in a direction perpendicular to the straight line 100, the leads can be equidistantly arranged in line as in the case shown in Figure 5 or 6.

### Confirmatory Test On Noise Elimination:

The four-terminal type noise filter of the present invention will now be described with respect to its noise eliminating ability.

### a) Test of Common Mode Noises:

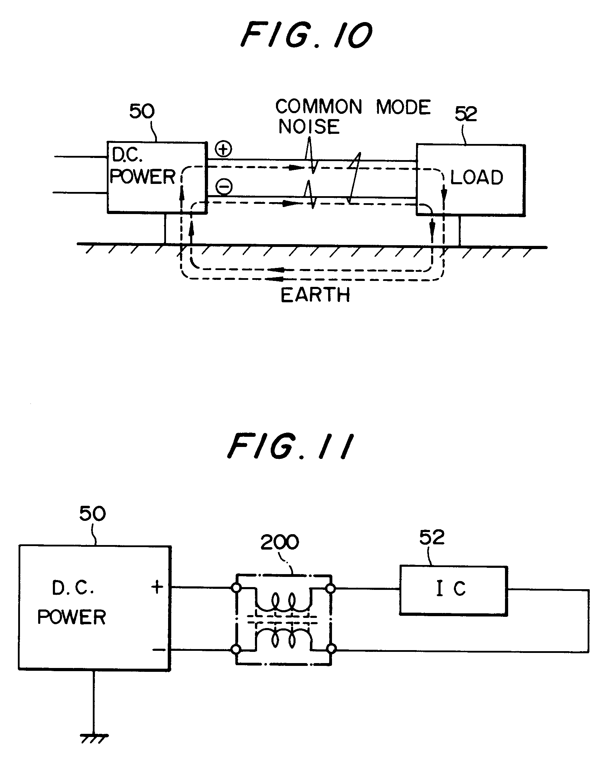

Figure 10 illustrates an electronic device comprising a load 52 such as an electronic circuit which receives DC voltage from a DC source 50 through power lines. In such an arrangement, the load 52 receives noises.

Noises received by the load 52 through the power lines are asymmetrical noises created on the earth side from the plus or minus side power line, to which noises the common mode noises are mostly belonged.

To eliminate such common mode noises, a noise filter 200 constructed according to the present invention is connected between the DC source 50 and the IC load 52, as shown in Figure 11.

The noise filter 200 used in this test was of such a type as shown in Figure 1 wherein each of the strip-like conductors 30-1 and 30-2 was formed of an aluminum foil having the overall length equal to 90 cm, width equal to 6 mm arid thickness equal to 15 µm. Each of the dielectric sheets 32-1 and 32-2 was a Mylar tape having its width equal to 8 mm and its thickness equal to 9 µm. A roll shaft 38 used to form a filter had a radius r equal to 1 mm.

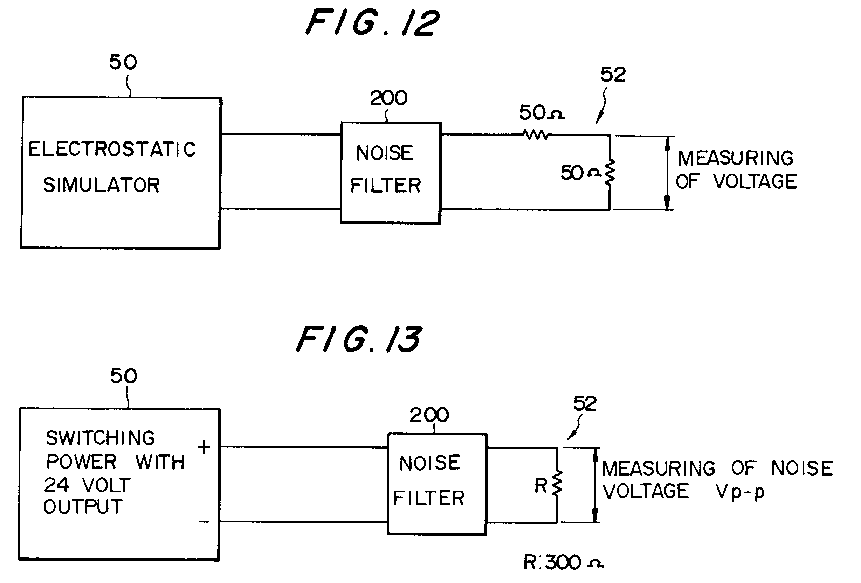

First of all, the electrostatic barrier test was performed by the use of a circuit shown in Figure 12.

At this time, an electrostatic simulator having its output voltage equal to 1 KV was used as the DC source 50 while two resistors each having a resistance equal to 50 Ohms were connected in series with each other to form the load 52.

Where the filter 200 of the present invention was not used, a voltage equal to 112.0 V was created between the opposite ends of the series resistors. When the filter 200 was used, however, it was found that the voltage between the opposite ends of the series resistors decreased from 112.0 V to 20.8 V.

Next, a circuit shown in Figure 13 was used to perform a test with respect to switching power output noises. In this test, a load 52 was a resistor of 300 Ohms.

When DC power source 50 was connected directly with the resistor 52 without use of the filter 200, noises having a level equal to 290 mVₚ₋ₚ were detected at the opposite ends of the resistor 52. When the filter 200 was connected between the DC power source 50 and the resistor 52, it was confirmed that the noises were reduced to 80 mVₚ₋ₚ.

The noise filter 200 of the present invention was substantially negligibly affected by ringing since it effectively reduced the common mode noises to attenuate any noise created by the ringing within very brief period of time.

It was thus found that the noise filter of the present invention had a superior noise attenuation by which various possible common mode noises such as electrostatic noises and switching surge noises could be positively eliminated without creation of ringing. This probably results from the fact that the noise filter of the present invention functions as a distributed constant type noise filter as shown in Figure 3, particularly with the component L of the distributed constant effectively serving to remove various possible common mode noise.

The advantages of the noise filter of the present invention were confirmed in comparison with the conventional noise filter.

The test used two types of filters, TH3820B and TH5130B, as noise filters relating to the present invention.

One of the noise filters TH3820B according to the present invention had strip-like conductors 30-1 and 30-2 each of which was made of an aluminum foil having 62 cm of overall length, 6 mm of width and 15 µm of thickness. Each of strip-like conductors 32-1 and 32-2 was made of Mylar tape having 8 mm of width and 9 µm of thickness. A roll shaft 38 used to make the filter had a radius r equal to 1.0 mm.

The other noise filter TH5130B comprised strip-like conductors 30-1 and 30-2 each of which was made of an aluminum foil having 90 cm of overall length, 6 mm of width and 9 µm of thickness and strip-like conductors 32-1 and 32-2 each of which was made of a polyester tape having 8mm of width and 9 µm of thickness. A roll shaft 38 used had a radius r equal to 1.0 mm.

The conventional noise filter was of a toroidal type as shown in Figure 15A. The toroidal noise filter included a ring-like core having an internal diameter equal to 6 mm, an external diameter equal to 14 mm and a width equal to 3 mm, as shown in Figure 15B. The outer periphery of the core had a coil formed by winding a wire having a diameter equal to 0.32 mm about the core through thirteen windings.

Figure 15C shows the equivalent circuit of the toroidal filter.

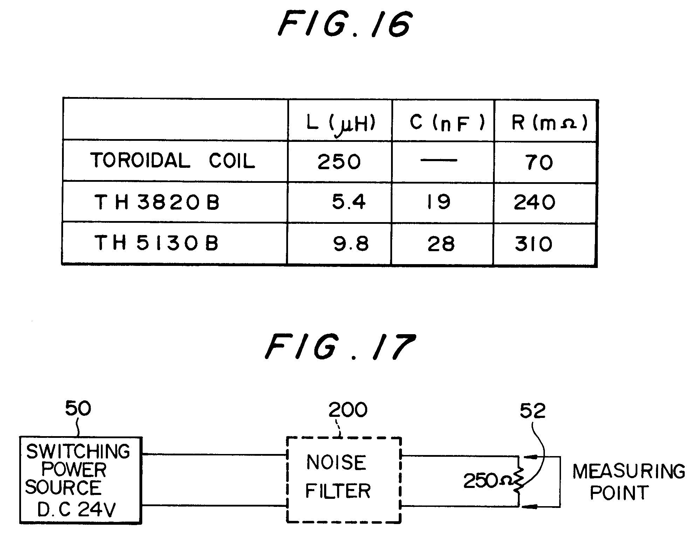

Figure 16 illustrates the electrical characteristics of the two noise filters TH3820B and TH5130B of the present invention and the conventional toroidal filter shown in Figure 15A. In Figure 16, all values L were measured at the terminals 36-1 and 34-1. Measuring frequency f was equal to one kHz.

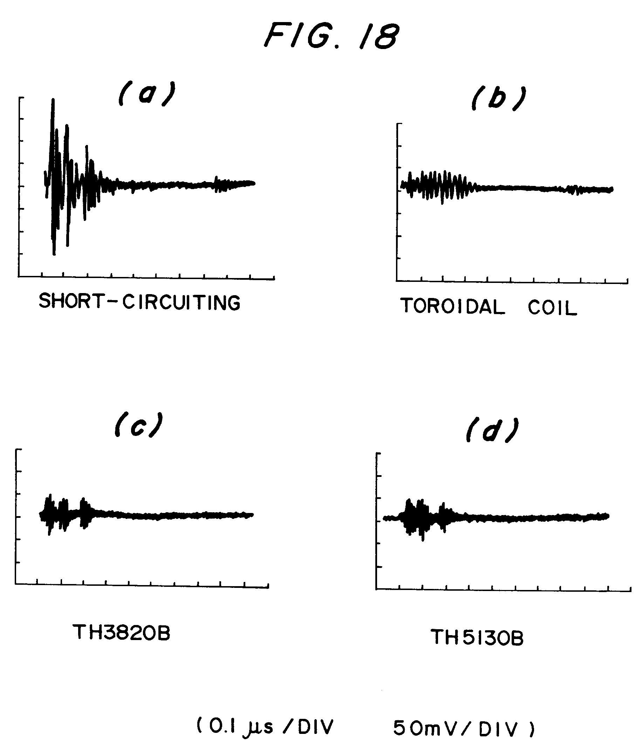

The filters so formed were used to measure switching power output noises which were a certain type of common mode noises, using a circuit shown in Figure 17. In this test, the load 52 was a resistor of 250 Ohms and the DC power source 50 was in 24 volts.

Figure 18 illustrates waveforms measured in the test, in which the axes of abscissas and ordinates represent time and measured voltage, respectively.

Figure 18A shows data measured when the measuring points are short-circuited; Figure 18B shows data measured when the toroidal noise filter is used; Figure 18C shows data measured in the noise filter TH3829B of the present invention; and Figure 18D shows data measured in the noise filter TH5130B of the present invention.

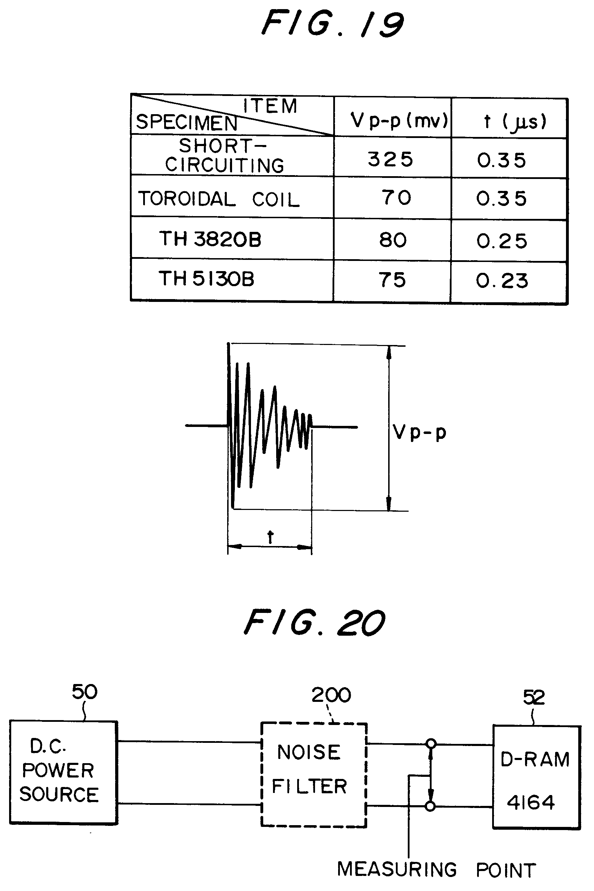

Figure 19 shows numerical data measured in the above test wherein Vₚ₋ₚ represents peak-to-peak value in common mode noise voltage and t indicates time required that the noises converge up to zero volts.

As will be understood from the above measurements, the noise filter of the present invention requires only very reduced time period to converge the common mode noises. Due to such an advantage, the noise filter of the present invention is substantially negligibly affected by the ringing.

### b) Test of Normal Mode Noises:

Next, a circuit shown in Figure 20 was used to test the reduction of normal mode noises. In this test, the reduction of ripple noise components were particularly measured in DC line for D-RAM.

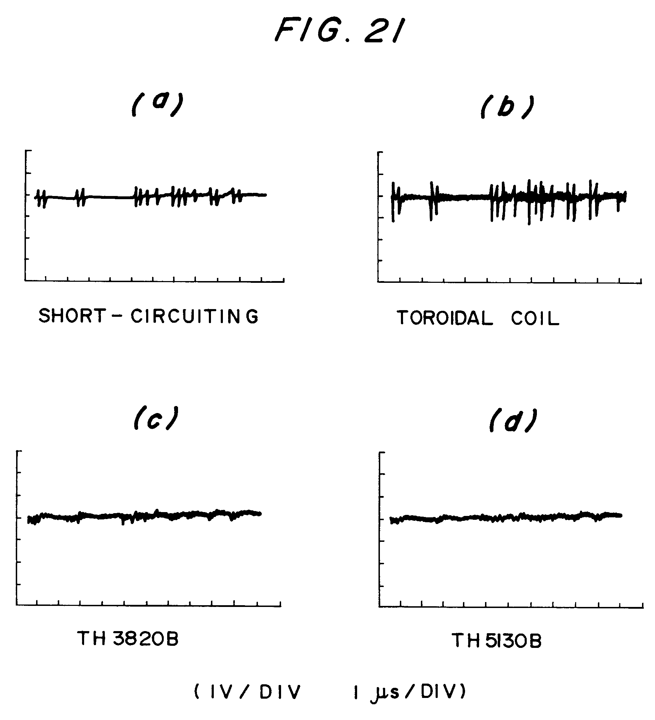

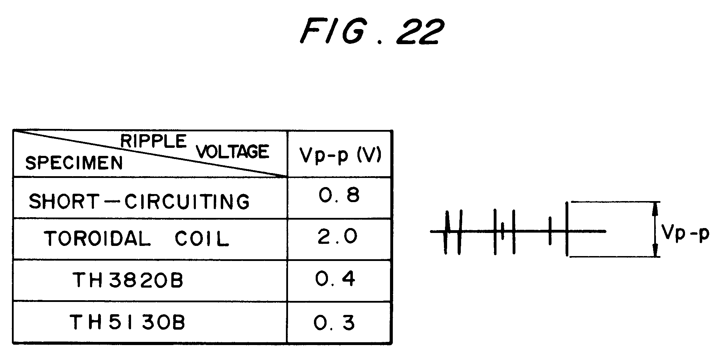

Figure 21 illustrates measurements resulting from such a test: Figure 21A shows data measured when the measuring points were short-circuited; Figure 21B shows data measured in the toroidal noise filter; Figure 21C shows data measured in the noise filter TH3820B of the present invention; Figure 21D shows data measured in the noise filter TH5130B of the present invention; and Figure 22 shows numerical measurements.

As will be seen from the above measurements, the toroidal filter provided increased ripple voltages in comparison with the absence of filter. On the other hand, the noise filters of the present invention highly reduce the ripple voltages.

In such a manner, it has been found that the noise filter of the present invention provides a superior noise attenuation by which various possible normal mode noises can positively be eliminated. This results from the fact that the noise filter of the present invention functions as a distributed constant type noise filter as shown in Figure 3, particularly with the component C of the distributed constant effectively acting to eliminate the normal mode noises

It is to be understood that the present invention is not limited to the illustrated embodiments, but can be modified and changed into various configurations without departing from the spirit and range of the present invention as claimed in the appendant claims. For example, the noise filter of the present invention may include a magnetic core within the central space of the roll 40 or be formed of magnetic conductors when it is desired to increase the inductance in the coils L₁ and L₂.

Although the illustrated embodiments have been described as to having two strip-like conductors 30-1 and 30-2 and two dielectric sheets 32-1 and 32-2, the present invention can be applied to such an arrangement that three strip-like conductors and three dielectric sheets are used to form a roll with two of these strip-like conductors having input/output leads.

Although the illustrated embodiments have been described also as to the noise filters used for DC line, the noise filter of the present invention may be similarly applied to AC line.

## Claims

1. A four-terminal type noise filter comprising a first strip-like conductor (30-1) having first inner and outer input/output leads (34-1, 34-2) each connected to said first conductor (30-1) adjacent each end, a second strip-like conductor (30-2) having second inner and outer input/output leads (36-1, 36-2) each connected to said second conductor (30-2) adjacent each end, and dielectric sheets (32-1, 32-2) super-posed on the respective conductors (30-1, 30-2), said conductors (30-1, 30-2) and dielectric sheets (32-1, 32-2) being together rolled into a tube such that said first and second inner leads (34-1, 36-1) define a set of input and output terminals and said first and second outer leads (34-2, 36-2) define another set of input and output terminals,
**characterized** in that
said tube has the shape of a flat ellipsoid, and said first and second inner and outer leads (34-1, 36-1; 34-2, 36-2) are arranged at least substantially in line and spaced equidistantly from one another on the main center axis of the flat ellipsoid.

2. A method of making the four-terminal type noise filter according to claim 1,
**characterized** by
the steps of superposing the two strip-like conductors (30-1, 30-2) one on another and on the respective dielectric sheets (32-1, 32-2) to form a laminate, connecting first and second inner input/output leads (34-1, 36-1) to the corresponding one of said strip-like conductors (30-1, 30-2) adjacent its inner end, rolling said laminate about a rotary roll shaft (38) through a plurality of turns, connecting first and second outer input/output leads (34-2, 36-2) to the respective one of said strip-like conductors (30-1, 30-2) adjacent its outer end such that the inner and outer leads (34-1, 36-1; 34-2, 36-2) will be positioned substantially on a diametrical line (100) passing through the rotational center (P) of said roll shaft (38) when said laminate is rolled about said roll shaft (38), removing said rolled laminate from said rotary roll shaft (38), and pressing said rolled laminate in a direction perpendicular to said diametrical line (100) to form an elliptic configuration wherein said leads (34-1, 34-2; 36-1, 36-2) are arranged in line.

3. A method of making the four-terminal type noise filter according to claim 1,
**characterized** by
the steps of superposing the two strip-like conductors (30-1, 30-2) one on another and on the respective dielectric sheets (32-1, 32-2) to form a laminate, connecting first and second inner input/output leads (34-1, 36-1) to the corresponding one of said strip-like conductors (30-1, 30-2) adjacent its inner end, rolling said laminate about a rotary roll shaft (36) through a plurality of turns, connecting first and second outer input/output leads (34-2, 36-2) to the respective one of said strip-like conductors (30-1, 30-2) adjacent its outer end such that the outer leads (34-2, 36-2) will be positioned substantially on a first diametrical line (100) passing through the rotational center (P) of said roll shaft (38) and such that the inner leads (34-1, 36-1) will be substantially positioned on another diametrical line (110) intersecting said first diametrical line (100) with a sharp angle when said laminate is rolled about said roll shaft (38), removing said rolled laminate from said rotary roll shaft (38), and pressing said rolled laminate in a direction perpendicular to said first diametrical (100) line to form an elliptic configuration wherein said leads (34-1, 34-2; 36-1, 36-2) are arranged substantially in line.

4. A method of making the four-terminal type noise filter according to claim 1,
**characterized** by
the steps of superposing the two strip-like conductors (30-1, 30-2) one on another and on the respective dielectric sheets (32-1, 32-2) to form a laminate, connecting first and second inner input/output leads (34-1, 36-1) to the corresponding one of said strip-like conductors adjacent its inner end, rolling said laminate about a rotary roll shaft (36) through a plurality of turns, connecting first and second outer input/output leads (34-2, 36-2) to the respective one of said strip-like conductors adjacent its outer end such that the outer leads (34-2, 36-2) will be positioned substantially on a diametrical line (100) passing through the rotational center of said roll shaft (38) and such that the inner leads (34-1, 36-1) will be substantially positioned symmetrically about a second diametrical line (200) perpendicular to said first diametrical line (100) when said laminate is rolled about said roll shaft (38), removing said rolled laminate from said rotary roll shaft (38), and pressing said rolled laminate in a direction perpendicular to said first diametrical line (100) to form an elliptic configuration wherein said leads (34-1, 34-2, 36-1, 36-2) are arranged substantially in line.

## Patentansprüche

1. Entstörfilter vom Vierpoltyp mit einem ersten streifenartigen Leiter (30-1), der eine erste innere und äußere Eingangs-/Ausgangs-Anschlußleitung (34-1, 34-2) aufweist, die jeweils an dem ersten Leiter (30-1) benachbart zu jedem Ende angeschlossen sind, mit einem zweiten streifenartigen Leiter (30-2), der eine zweite innere und äußere Eingangs-/Ausgangs-Anschlußleitung (36-1, 36-2) aufweist, die jeweils an dem zweiten Leiter (30-2) benachbart zu jedem Ende angeschlossen sind, und mit dielektrischen Schichten (32-1, 32-2), die über den jeweiligen Leitern (30-1, 30-2) angeordnet sind, wobei die Leiter (30-1, 30-2) und die dielektrischen Schichten (32-1, 32-2) miteinander derart zu einem Rohr gewickelt sind, daß die erste und die zweite innere Anschlußleitung (34-1, 36-1) einen Satz von Eingangs- und Ausgangspolen definieren und die erste und die zweite äußere Anschlußleitung (34-2, 36-2) einen weiteren Satz von Eingangs- und Ausgangspolen definieren,
dadurch **gekennzeichnet**,
daß das Rohr die Form eines flachen Ellipsoids aufweist und die ersten und zweiten inneren und äußeren Anschlußleitunge (34-1, 36-1; 34-2, 36-2) wenigstens im wesentlichen in einer Linie angeordnet und auf der großen Mittelachse des flachen Ellipsoids äquidistant voneinander beabstandet sind.

2. Verfahren zum Herstellen des Entstörfilters vom Vierpoltyp nach Anspruch 1,
**gekennzeichnet durch**
folgende Schritte: Anordnen der zwei streifenartigen Leiter (30-1, 30-2) aufeinander und auf den jeweiligen dielektrischen Schichten (32-1, 32-2), um ein Laminat zu bilden, Anschließen der ersten und der zweiten inneren Eingangs-/Ausgangs-Anschlußleitung (34-1, 36-1) an dem entsprechenden der streifenartigen Leiter (30-1, 30-2) benachbart zu seinem inneren Ende, Wickeln des Laminats um eine Rotations-Walzenspindel (38) über eine Vielzahl von Windungen, wenn das Laminat um die Walzenspindel (38) gewickelt wird derartiges Anschließen der ersten und der zweiten äußeren Eingangs-/Ausgangs-Anschlußleitung (34-2, 36-2) an dem jeweiligen der streifenartigen Leiter (30-1, 30-2) benachbart zu seinem äußeren Ende, daß die inneren und die äußeren Anschlußleitungen (34-1, 36-1; 34-2, 36-2) im wesentlichen auf einer diametralen Linie (100) positioniert werden, die durch das Rotationszentrum (P) der Walzenspindel (38) verläuft, Entfernen des gewickelten Laminats von der Rotations-Walzenspindel (38), und Drücken des gewickelten Laminats in einer Richtung, die rechtwinklig zu der diametralen Linie (100) ist, zum Bilden einer elliptischen Form, wobei die Anschlußleitungen (34-1, 34-2; 36-1, 36-2) in einer Linie angeordnet werden.

3. Verfahren zum Herstellen des Entstörfilters vom Vierpoltyp nach Anspruch 1,
**gekennzeichnet durch**
folgende Schritte: Anordnen der zwei streifenartigen Leiter (30-1, 30-2) aufeinander und auf die jeweiligen dielektrischen Schichten (32-1, 32-2), um ein Laminat zu bilden, Anschließen der ersten und der zweiten inneren Eingangs-/Ausgangsleitung (34-1, 36-1) an dem entsprechenden der streifenartigen Leiter (30-1, 30-2) benachbart zu seinem inneren Ende, Wickeln des Laminats um eine Rotations-Walzenspindel (38) über eine Vielzahl von Windungen, wenn das Laminat um die Walzenspindel (38) gewickelt wird derartiges Anschließen der ersten und der zweiten äußeren Eingangs-/Ausgangs-Anschlußleitung (34-2, 36-2) an dem jeweiligen der streifenartigen Leiter (30-1, 30-2) benachbart zu seinem äußeren Ende, daß die äußeren Anschlußleitungen (34-2, 36-2) im wesentlichen auf einer ersten diametralen Linie (100) positioniert werden, die durch das Rotationszentrum (P) der Walzenspindel (38) verläuft, und daß die inneren Anschlußleitungen (34-1, 36-1) im wesentlichen auf einer weiteren diametralen Linie (110) positioniert werden, die die erste diametrale Linie (100) bei einem spitzen Winkel schneidet, Entfernen des gewickelten Laminats von der Rotations-Walzenspindel (38), und Drücken des gewickelten Laminats in einer Richtung, die rechtwinklig zu der ersten diametralen Linie (100) ist, zum Bilden einer elliptischen Form, wobei die Anschlußleitungen (34-1, 34-2; 36-1, 36-2) im wesentlichen in einer Linie angeordnet werden.

4. Verfahren zum Herstellen des Entstörfilters vom Vierpoltyp nach Anspruch 1,
**gekennzeichnet durch**
folgende Schritte: Anordnen der zwei streifenartigen Leiter (30-1, 30-2) aufeinander und auf den jeweiligen dielektrischen Schichten (32-1, 32-2), um ein Laminat zu bilden, Anschließen der ersten und der zweiten inneren Eingangs-/Ausgangs-Anschlußleitung (34-1, 36-1) an dem entsprechenden der streifenartigen Leiter benachbart zu seinem inneren Ende, Wickeln des Laminats um eine Rotations-Walzenspindel (38) über eine Vielzahl von Windungen, wenn das Laminat um die Walzenspindel (38) gewickelt wird derartiges Anschließen der ersten und der zweiten äußeren Eingangs-/Ausgangs-Anschlußleitung (34-2, 36-2) an dem jeweiligen der streifenartigen Leiter benachbart zu seinem äußeren Ende, daß die äußeren Anschlußleitungen (34-2, 36-2) im wesentlichen auf einer diametralen Linie (100) positioniert werden, die durch das Rotationszentrum der Walzenspindel (38) verläuft, und daß die inneren Anschlußleitungen (34-1, 36-1) im wesentlichen symmetrisch um eine zweite diametrale Linie (200) positioniert werden, die rechtwinklig zu der ersten diametralen Linie (100) ist, Entfernen des gewickelten Laminats von der Rotations-Walzenspindel (38), und Drücken des gewickelten Laminats in einer Richtung, die rechtwinklig zu der ersten diametralen Linie (100) ist, zum Bilden einer elliptischen Form, wobei die Anschlußleitungen (34-1, 34-2; 36-1, 36-2) im wesentlichen in einer Linie angeordnet werden.

## Revendications

1. Filtre de bruit du type à quatre bornes comprenant un premier conducteur en forme de bande (30-1) muni d'un premier fil électrique intérieur et d'un premier fil électrique extérieur d'entrée/sortie (34-1, 34-2) branchés chacun au premier conducteur (30-1) au voisinage de chaque extrémité, un second conducteur en forme de bande (30-2) muni d'un second fil électrique intérieur et d'un second fil électrique extérieur d'entrée/sortie (36-1, 36-2) branchés chacun au second conducteur (30-2) au voisinage de chaque extrémité, et des feuilles diélectriques (32-1, 32-2) superposées sur les conducteurs respectifs (30-1, 30-2), ces conducteurs (30-1, 30-2) et ces feuilles diélectriques (32-1, 32-2) étant enroulés ensemble pour former un tube de façon que le premier fil électrique intérieur et le second fil électrique intérieur (34-1, 36-1) définissent un jeu de bornes d'entrée et de sortie tandis que le premier fil électrique extérieur et le second fil électrique extérieur (34-2, 36-2) définissent un autre jeu de bornes d'entrée et de sortie,
caractérisé en ce que le tube présente la forme d'un ellipsoïde plat, et en ce que les premiers et seconds fils électriques intérieurs et extérieurs (34-1, 36-1 ; 34-2, 36-2) sont disposés au moins essentiellement en ligne et espacés les uns des autres par des distances égales sur l'axe central principal de l'ellipsoïde plat.

2. Procédé de fabrication du filtre de bruit du type à quatre bornes selon la revendication 1,
caractérisé en ce qu'il comprend les étapes consistant à superposer les deux conducteurs en forme de bande (30-1, 30-2) l'un sur l'autre et sur les feuilles diélectriques respectives (32-1, 32-2) pour former un stratifié, à brancher le premier fil électrique intérieur et le second fil électrique intérieur d'entrée/sortie (34-1, 36-1) à l'un correspondant des conducteurs en forme de bande (30-1, 30-2) au voisinage de son extrémité intérieure, à enrouler le stratifié, sur un rouleau de mandrin rotatif (38) en formant un certain nombre de tours, à brancher le premier fil électrique extérieur et le second fil électrique extérieur d'entrée/sortie (34-2, 36-2) à l'un correspondant des conducteurs en forme de bande (30-1, 30-2) au voisinage de son extrémité extérieure, de façon que les fils électriques intérieurs et extérieurs (34-1, 36-1 ; 34-2, 36-2) soient positionnés essentiellement sur une ligne diamétrale (100) passant par le centre de rotation (P) du rouleau de mandrin (38) lorsque le stratifié est enroulé sur ce rouleau de mandrin (38), à retirer le stratifié enroulé du rouleau de mandrin rotatif (38), et à presser le stratifié enroulé dans une direction perpendiculaire à la ligne diamétrale (100) pour former une configuration elliptique dans laquelle les fils électriques (34-1, 34-2 ; 36-1, 36-2) sont disposés en ligne.

3. Procédé de fabrication du filtre de bruit du type à quatre bornes selon la revendication 1,
caractérisé en ce qu'il comprend les étapes consistant à superposer les deux conducteurs en forme de bande (30-1, 30-2) l'un sur l'autre et sur les feuilles diélectriques respectives (32-1, 32-2) pour former un stratifié, à brancher le premier fil électrique intérieur et le second fil électrique intérieur d'entrée/sortie (34-1, 36-1) à l'un correspondant des conducteurs en forme de bande (30-1, 30-2) au voisinage de son extrémité intérieure, à enrouler le stratifié sur un rouleau de mandrin rotatif (36) en formant un certain nombre de tours, à brancher le premier fil électrique extérieur et le second fil électrique extérieur d'entrée/sortie (34-2, 36-2) à l'un correspondant des conducteurs en forme de bande (30-1, 30-2) au voisinage de son extrémité extérieure, de façon que les fils électriques extérieurs (34-2, 36-2) soient positionnés essentiellement sur une première ligne diamétrale (100) passant par le centre de rotation (P) du rouleau de mandrin (38), et de façon que les fils électriques intérieurs (34-1, 36-1) soient essentiellement positionnés sur une autre ligne diamétrale (110) coupant la première ligne diamétrale (100) sous un angle aigu lorsque le stratifié est enroulé sur le rouleau de mandrin (38), à retirer le stratifié enroulé du rouleau de mandrin rotatif (38), et à presser le stratifié enroulé dans une direction perpendiculaire à la première ligne diamétrale (100) pour former une configuration elliptique dans laquelle les fils électriques (34-1, 34-2 ; 36-1, 36-2) sont disposés essentiellement en ligne.

4. Procédé de fabrication du filtre de bruit du type à quatre bornes selon la revendication 1,
caractérisé en ce qu'il comprend les étapes consistant à superposer les deux conducteurs en forme de bande (30-1, 30-2) l'un sur l'autre et sur les feuilles diélectriques respectives (32-1, 32-2) pour former un stratifié, à brancher le premier fil électrique intérieur et le second fil électrique intérieur d'entrée/sortie (34-1, 36-1) à l'un correspondant des conducteurs en forme de bande au voisinage de son extrémité intérieure, à enrouler le stratifié sur un rouleau de mandrin rotatif (38) en formant un certain nombre de tours, à brancher le premier fil électrique extérieur et le second fil électrique extérieur d'entrée/sortie (34-2, 36-2) à l'un correspondant des conducteurs en forme de bande au voisinage de son extrémité extérieure, de façon que les fils électriques extérieurs (34-2, 36-2) soient positionnés essentiellement sur une ligne diamétrale (100) passant par le centre de rotation du rouleau de mandrin (38), et de façon que les fils électriques intérieurs (34-1, 36-1) soient positionnés essentiellement symétriquement autour d'une seconde ligne diamétrale (200) perpendiculaire à la première ligne diamétrale (100) lorsque le stratifié est enroulé sur le rouleau de mandrin (38), à retirer le stratifié enroulé du rouleau de mandrin rotatif (38), et à presser le stratifié enroulé dans une direction perpendiculaire à la première ligne diamétrale (100) pour former une configuration elliptique dans laquelle les fils électriques (34-1, 34-2 ; 36-1, 36-2) sont disposés essentiellement en ligne.
